# EUROPÄISCHE PATENTSCHRIFT

(11) **EP 3 371 611 B1**
(45) Veröffentlichungstag und Bekanntmachung des Hinweises auf die Patenterteilung: **30.12.2020**
(21) Anmeldenummer: 17803802.2
(22) Anmeldetag: 30.10.2017
(51) Int. Cl.: G01R 31/11

(54) **VERFAHREN UND MESSANORDNUNG ZUR ÜBERWACHUNG EINER LEITUNG**
METHOD AND MEASURING ASSEMBLY FOR MONITORING A LINE
PROCÉDÉ ET SYSTÈME DE MESURE SERVANT À LA SURVEILLANCE D'UNE LIGNE

(30) Priorität: 11.11.2016 DE 102016222233
(43) Veröffentlichungstag der Anmeldung: 12.09.2018
(73) Patentinhaber: LEONI Kabel GmbH, 91154 Roth (DE)
(72) Erfinder: JANSSEN, Bernd, 26169 Friesoythe OT Neuscharrel (DE); WEBER, Heiko, 26845 Nortmoor (DE)
(74) Vertreter: FDST Patentanwälte
(86) Internationale Anmeldenummer: PCT/EP2017/077828
(87) Internationale Veröffentlichungsnummer: WO 2018/086949

(56) Entgegenhaltungen:
- EP-A2- 1 186 906
- WO-A1-94/16303
- WO-A1-2007/090467
- WO-A1-2008/135052
- DE-A1- 3 712 780
- DE-T2- 69 022 418
- US-A1- 2002 177 961
- US-A1- 2005 052 190
- US-A1- 2005 057 880
- US-A1- 2005 073 321
- US-A1- 2005 213 684
- US-A1- 2006 007 991
- US-A1- 2006 012 376
- US-A1- 2011 015 882
- US-A1- 2011 285 399
- US-A1- 2013 162 262
- US-A1- 2015 212 025
- US-B1- 6 707 307
- US-B1- 6 771 076
- US-B1- 8 582 443

## Beschreibung

Die Erfindung betrifft ein Verfahren sowie eine Messanordnung zur Überwachung einer Leitung auf Abweichungen von einem Normalzustand.

Die Leitung weist hierzu einen Messleiter auf, welcher sich entlang der gesamten Länge der Leitung erstreckt.

Die Leitung dient beispielsweise der Übertragung von Energie und/ oder Signalen und weist hierzu zumindest eine Ader, üblicherweise mehrere Adern, dass heißt isolierte Leiter auf. Mehrere Adern sind oftmals mittels eines gemeinsamen Leitungsmantels zu einer Leitung zusammengefasst. Speziell bei Daten - oder Signalleitungen sind häufig noch Schirmlagen ausgebildet. Bei vielen Anwendungen beispielsweise im Automotiv-Bereich unterliegen Leitungen diversen Belastungen, welche bezüglich Dauer und Stärke unbekannt sind. Auch die häufig variierenden Umgebungsbedingungen, zum Beispiel Wärmeeinflüsse, können oftmals nicht oder nicht hinreichend abgeschätzt werden, um den Verschleiß einer Leitung vorhersagen zu können. Daneben unterliegen die Leitungen häufig auch einer mechanischen Belastung, beispielsweise durch Vibrationen, welche zu einer Beschädigung führen können. Um eine bestimmte Mindestlebensdauer garantieren zu können, wird eine Leitung daher typischerweise überdimensioniert ausgelegt. Alternativ besteht auch die Möglichkeit, die Leitung im Betrieb oder zumindest in regelmäßigen Abständigen zu überwachen und zu kontrollieren.

Ein bekanntes Verfahren zur Überprüfung einer Leitung auf Defekte ist die sogenannte Zeitbereichsreflektometrie, kurz TDR (Time Domain Reflectometry). Dabei wird in einen Leiter, welcher sich entlang der Leitung erstreckt, ein Messpuls eingespeist und der Spannungsverlauf eines Antwortsignals ausgewertet. Hierbei wird mit einer vergleichsweise aufwendigen und teuren Messapparatur der tatsächliche Spannungsverlauf erfasst und entsprechend ausgewertet. Die TDR wird üblicherweise in Messlaboren oder bei aufwendigen Messanordnungen eingesetzt. Sie ist zudem sehr ESD (electrostatic discharge) sensibel.

Für eine routinemäßige Überprüfung einer Leitung beispielsweise im Industrie- oder -im Automotiv-Bereich ist ein derartiges Verfahren jedoch aufgrund der damit verbundenen Kosten, der Komplexität sowie Störanfälligkeit nicht geeignet.

Aus der US 2005/052190 A1 ist ein TDR-System zu entnehmen, bei dem ein Messsignal eingespeist wird und die Laufzeit bis Eingang eines an einem Kabelende reflektierten Signals bei Überschreiten eines Schwellwerts erfasst. Zur genauen Erfassung der Laufzeit und zur Unterscheidung von unterschiedlichen Kabelenden wird der Schwellwert variiert.

In der WO 94/16303 A1 ist eine Leckdetektion an einer Fluidleitung mit Hilfe einer TDR-Messung beschrieben. Auf ein Leck wird erkannt, wenn das reflektierte Signal einen Schwellwert überschreitet. Zur Untersuchung unterschiedlicher Abschnitte der Fluidleitung werden unterschiedliche Abtastfenster für die TDR-messung vorgegeben.

Aus der EP 1 186 906 A2 ist eine Entfernungsmessung, speziell eine Füllstandsmessung auf Basis der Messung von Signallaufzeiten zu entnehmen. Ausgewertet wird die Zeitdifferenz zwischen Aussenden eines Messimpulses und Empfang des reflektierten Impulses. Ein weiteres System zur Füllstandsmessung ist aus der DE 690 22 418 T2 zu entnehmen.

Die US 2005/0213684 A1 beschreibt eine TDR-Messung zur Bestimmung einer Kabellänge oder zur Erfassung von Fehlstellen im Kabel.

Aus der US 2013/0162262 A1 ist u.A. die Temperaturmessung mit Hilfe eines TDR-Systems zu entnehmen.

Die US 2005/073321 A1 beschreibt die Auswertung einer Signallaufzeit bis zu einer Störstelle für eine Feuchtemessung.

Die US 2006/007991 A1 befasst sich ebenfalls mit der Identifizierung von Fehlern in Kabeln mit Hilfe der Auswertung eines an einer Störstelle reflektierten Signals.

Vor diesem Hintergrund liegt der Erfindung die Aufgabe zu Grunde, ein Verfahren sowie eine Messanordnung anzugeben, mittels derer eine kostengünstige, insbesondere wiederkehrende oder regelmäßige Überwachung einer Leitung ermöglicht ist. Die Überwachung soll dabei insbesondere in einem eingebauten Zustand der Leitung in einem Endprodukt und/ oder in einem vorgesehenen Betrieb der Leitung erfolgen.

Die Aufgabe wird erfindungsgemäß gelöst durch ein Verfahren mit den Merkmalen gemäß Anspruch 1 sowie durch eine Messanordnung mit den Merkmalen gemäß Anspruch 12. Bevorzugte Ausgestaltungen des Verfahrens sowie der Messanordnung sind jeweils in den Unteransprüchen enthalten. Die im Hinblick auf das Verfahren angeführten Vorteile sowie bevorzugten Ausgestaltungen sind sinngemäß auf die Messanordnung und umgekehrt zu übertragen.

Durch das Verfahren sowie die Messanordnung ist mit einem einfachen kostengünstigen Aufbau eine Überwachung einer die Leitung betreffenden Zustandsgröße ermöglicht. Bei der Zustandsgröße handelt es sich beispielsweise um eine interne Zustandsgröße der Leitung, so dass also der Leitungszustand selbst überwacht wird. Alternativ wird eine äußere Zustandsgröße überprüft. Bei dieser Variante wird daher mittelbar der Zustand der Umgebung, beispielweise einer zu überwachenden Komponente überprüft.

Die mit dem Verfahren zu überwachende Leitung weist einen Messleiter auf, in den ein Messsignal zu einer Startzeit eingespeist wird. Der Messleiter wird nunmehr auf das Vorliegen einer Störstelle überwacht. Unter Störstelle wird allgemein ein Ort verstanden, an dem das Messsignal zumindest teilweise reflektiert wird. Eine zumindest teilweise Reflektion erfolgt typischerweise bei einer Änderung des Wellenwiderstands des Messleiters infolge der Störstelle. Bei der Störstelle kann es sich auch um ein Leitungsende oder eine Anschlussstelle handeln. Der Messleiter wird im Hinblick auf einen zurücklaufenden Anteil überwacht, der an einem Leitungsende oder an einer oder an mehreren anderen Störstellen reflektiert wird. Die Amplitude des zurücklaufenden Anteils wird erfasst und bei Überschreiten eines vorgegebenen Spannungsschwellwertes, nachfolgend kurz Schwellwert, wird ein digitales Stoppsignal erzeugt. Weiterhin wird die Laufzeit zwischen der Startzeit und dem Stoppsignal erfasst und ausgewertet. Liegt keine Störstelle vor, so wird kein Stoppsignal erzeugt, was auf eine intakte Leitung hindeutet.

Unter Überschreiten eines Schwellwertes wird insbesondere ein positives Überschreiten von einem Wert unterhalb des Schwellwerts zu einem Wert oberhalb des Schwellwerts verstanden (Überschreiten im engeren Sinn). Vorzugsweise wird unter Überschreiten des Schwellwertes zusätzlich auch ein negatives Überschreiten von einem höheren Wert zu einem niedrigeren Wert verstanden (Unterschreiten im engeren Sinn).

Das Überschreiten der Schwelle wird vorzugsweise mit Hilfe eines Komparators ermittelt, der also ein Stoppsignal beim Überschreiten der Schwelle abgibt, insbesondere sowohl bei einem positiven als auch bei einem negativen Überschreiten. Der Schwellwert ist entsprechend der Definition eines Schwellwerts grundsätzlich ungleich Null und beträgt beispielsweise zumindest 10% oder mehr der Amplitude des eingespeisten Signals. Sofern eine Überlagerung des reflektierten Anteils mit dem eingespeisten Signal erfolgt liegt der Schwellwert beispielsweise zumindest 10% über oder unter der Amplitude des eingespeisten Signals.

Von entscheidender Bedeutung für die kostengünstige Ausgestaltung des Verfahrens ist die Erzeugung lediglich eines digitalen Stoppsignals bei Überschreitung eines Schwellwertes für den reflektierten Anteil. Unter digitalem Stoppsignal wird hierbei ein binäres Signal verstanden, welches lediglich eine digitale Zustandsinformation ja / nein (bzw. 1 / 0) übermittelt. Es enthält daher keine Information über die Amplitudenhöhe des reflektierten Signals. Eine Aussage zu der Amplitude ergibt sich in Kombination mit dem gewählten Schwellwert, welcher also eine Auslöseschwelle für das Stoppsignal ist. Anhand des Stoppsignals in Kombination mit dem Schwellwert ist daher eine Zuordnung einer (Mindest-) Amplitude des reflektierten Signals möglich, ohne dass diese Amplitude gemessen werden muss.

Das Stoppsignal kann dabei grundsätzlich ein analoges Signal sein, ist vorzugsweise jedoch ein digitales Signal beispielsweise in Form eines Spannungsimpulses oder auch eines Spannungsprungs. Durch das Stoppsignal ist eine vergleichsweise einfache Auswerteschaltung ermöglicht. Anders als bei einer TDR-Messung ist daher gerade keine zeitaufgelöste Messung des tatsächlichen Spannungsverlaufs vorgesehen. Es wird keine TDR-Messung durchgeführt. Pro Einzelmessung, d.h. nach Aussenden des / jedes Messsignals, wird insbesondere genau ein Stoppsignal zu einem definierten Spannungs-Schwellwert erzeugt und ausgewertet. Das erfindungsgemäße Verfahren lässt sich in einfacher Weise mit digitaler Schaltungstechnologie umsetzen. Ein Analog-/Digitalwandler, wie er bei TDR-Messanordnung erforderlich ist, wird vorliegend nicht eingesetzt.

Die Reflektion erfolgt an einer Störstelle, oder allgemein an einer Stelle an der sich der Wellenwiderstand für das sich ausbreitende Messsignal ändert. Die Messanordnung ist insbesondere derart ausgebildet, dass am Leitungsende des Messleiters eine Teil- oder Totalreflektion des Messsignals erfolgt. Hierzu weist der Messleiter insbesondere ein sogenanntes offenes Ende auf.

Grundsätzlich ist eine absolute Auswertung der gemessenen Laufzeit zwischen Startzeit und Stoppsignal möglich. So kann beispielsweise bei bekannter Leitungslänge, bekanntem Wellenwiderstand und im Falle einer bekannten Temperaturabhängigkeit eines den Messleiter umgebenden (temperaturabhängigen) Dielektrikums unmittelbar aus der Laufzeit auf die aktuelle Temperaturbelastung des Messleiters zurückgeschlossen werden. Auch ist aus der tatsächlich gemessenen Laufzeit beispielsweise auch der Ort einer Störstelle, beispielsweise ein Knick in der Leitung etc. unmittelbar erfassbar. Für die Messung wird vorzugsweise lediglich eine Messung über den Messleiter (in Verbindung mit einen Rückleiter) durchgeführt, insbesondere ohne dass ein zusätzlicher Referenzleiter verwendet ist, in den beispielsweise das Messsignal parallel als Referenzsignal eingespeist (und ggf. ein reflektiertes Signal ausgewertet) wird.

Eine derartige Absolut-Auswertung erfordert in der Regel jedoch eine hohe Genauigkeit bei der Auswertung und insbesondere auch sehr genaue Kenntnisse über die Eigenschaften der Leitung. Es ist daher ein Vergleich mit einer vorgegebenen Referenz vorgesehen. Zumindest ist ein Vergleich mit einer Referenzdauer für eine Laufzeit für einen Normalzustand der Leitung vorgesehen. Bei einer Abweichung zu der Referenzdauer wird auf eine Abweichung von einem Normalzustand erkannt.

Im einfachsten Fall weist die Leitung lediglich den Messleiter sowie einen typischerweise erforderlichen Rückleiter auf. In einem solchen Fall ist die Leitung daher beispielsweise als eine reine Sensorleitung ausgebildet, die beispielsweise - neben der Erfassung der einen oder mehreren Zustandsgrößen - keine weitere Funktion hat. Alternativ ist der Messleiter Bestandteil einer Leitung, die zur Daten- und / oder Leistungsübertragung ausgebildet ist und beispielsweise mehrere Übertragungselemente aufweist. In einer Ausführungsvariante erfolgt über den Messleiter auch eine Übertragung von Daten oder von Leistung. Der Messleiter hat daher in dieser Variante eine Doppelfunktion als Messleiter und als normaler Leiter zur Übertragung von Daten / elektrischer Leistung. Für das vorliegende Messkonzept muss daher eine herkömmliche, bestehende Leitung nicht zwingend um einen zusätzlichen Messleiter erweitert werden.

Es wird ein Messzyklus mit mehreren aufeinanderfolgende Einzelmessungen durchgeführt, wobei bei jeder Einzelmessung genau ein Stoppsignal erzeugt wird, so dass mehrere Stoppsignale mit unterschiedlichen Laufzeiten erhalten werden. Bei jeder Einzelmessung wird dabei ein Wertepaar aus dem eingestellten Schwellwert und der Laufzeit festgehalten und abgespeichert. Die mehreren Stoppsingale erstrecken sich dabei insbesondere über einen Zeitbereich von zumindest 10%, vorzugsweise von zumindest 30% und weiter vorzugsweise von zumindest 50% oder von zumindest 75% einer Gesamtlaufzeit eines am Leitungsende reflektierten Anteils. Bevorzug umfasst der Zeitbereich die Gesamtlaufzeit eines am Leitungsende reflektierten Anteils (bei Normalbedingungen, trocken, 20°C). Die Gesamtlaufzeit ergibt sich dabei durch die Zeitspanne vom Einspeisen des Messsignals in den Messleiter an einem Einspeiseort bis zum Eintreffen des am Leitungsende reflektierten Anteils am Einspeiseort. Durch diese Maßnahme wird ermöglicht, dass über die Leitungslänge verteilte Störstellen erfasst werden oder dass bestimmte Störstellen im Hinblick auf den durch Sie verursachten Signalverlauf genauer ausgemessen werden. Es wird daher - zumindest über einen Teilbereich - der tatsächliche Signalverlauf durch die Mehrzahl der Stoppsignale nachgebildet, also speziell durch die Vielzahl der zu jedem Stoppsignal erhaltenen Wertepaare (Höhe des Schwellwertes und Laufzeit). Diese Wertepaare werden also abgespeichert und ausgewertet, so dass aus diesen ein Signalverlauf nachgebildet wird.

Für den Messzyklus wird daher eine Abfolge von einzelnen Messsignalen in den Messleiter eingespeist (pro Einzelmessung ein Messsignal). Das jeweilige Messsignal ist dabei als ein Rechtecksignal ausgebildet und zwischen zwei aufeinanderfolgenden Messsignalen liegt eine Pause an. Die Pausenzeit, also die Zeit zwischen zwei Messsignalen, ist vorzugsweise größer, beispielsweise um zumindest den Faktor 1,5 oder 2, als die Dauer des Messsignals. Das Verhältnis von Pausenzeit zur Signalzeit (Pulszeit) liegt beispielsweise bei 2:1. Speziell variiert dieses Verhältnis im Laufe des Messzykluses.

Vorzugsweise ist weiterhin eine maximale Dauer für das Messsignal vorgegeben. Das Messsignal wird beispielsweise nach Erkennen des Stoppsignals abgebrochen. D.h. die Dauer des Messsignals variiert typischerweise zwischen den Einzelmessungen. Sofern jedoch kein Stoppsignal erfasst wird, endet das Messsignal nach Erreichen der vorgegebenen maximalen Dauer und die Messung wird beendet.

Häufig weisen Leitungen im eingebauten Zustand bereits - abweichend von einem idealisierten Zustand - geringfügige Störeffekte auf, die den Normalzustand definieren, jedoch für den normalen Betrieb unkritisch sind. Jede dieser Störstellen erzeugt dabei eine Teilreflektion des Messsignals. Eine jeweilige Leitung weist daher bereits im Normalzustand ein charakteristisches Muster von vorzugsweise mehreren reflektierten Anteilen auf, welches nachfolgend als Referenzmuster bezeichnet wird. Umgekehrt weist die zu überprüfende Leitung nach einer gewissen Betriebsdauer ebenfalls ein die Leitung zu diesem Zeitpunkt charakterisierendes Stoppmuster mit dem zumindest einen Stoppsignal auf. Das Stoppmuster wird mit dem Referenzmuster verglichen und im Hinblick auf Abweichungen überprüft. Neben den Laufzeiten der einzelnen unterschiedlichen rücklaufenden reflektierten Anteile wird insbesondere auch die Höhe der Spannungswerte der reflektierten Anteile erfasst und ausgewertet. Das Referenz- oder Stoppmuster wird dabei gebildet durch eine Anzahl von Stoppsignalen mit unterschiedlichen Laufzeiten.

Weiterhin ist der Schwellwert variabel einstellbar. Hierdurch ist beispielsweise eine Auswertung der reflektierten Anteile im Hinblick auf ihre Signalhöhe (Spannungswert) ermöglicht. Aufgrund des Messprinzips mit der Erzeugung lediglich eines digitalen Stoppsignals bei der Überschreitung eines Schwellwertes wird also durch die Variation des Schwellwertes auch eine Auswertung im Hinblick auf die Signalhöhe, also die Signalspannung des reflektierten Anteils ermöglicht und vorgenommen. Es wird also die tatsächliche Signalhöhe des reflektierten Anteils ermittelt. Durch diese Maßnahme lassen sich unterschiedliche Fehlerfälle oder Situationen erfassen. Die Variation des Schwellwerts in Kombination mit dem Messzyklus aus mehreren Einzelmessungen ermöglicht zudem, einen Signalverlauf mit an- und / oder abfallenden Flanken zu approximieren.

In bevorzugter Ausgestaltung wird der Schwellwert dabei über einen Bereich variiert, der der zumindest dem 0,5 fachen und bevorzugt zumindest dem 0,75 fachen der Amplitude des Messsignals entspricht. Insbesondere wird der Schwellwert beispielsweise über einen Bereich zwischen dem 0,2-fachen bis zum 0,9-fachen oder auch bis zum 1-fachen der Amplitude des Messsignals variiert. Durch sukzessive Einzelmessungen und der Variation des Schwellwertes wird dann ein Signalverlauf erstellt oder angenähert. Durch die Variation über einen vergleichsweise großen Bereich der Amplitude des Messsignals werden sowohl Störstellen mit einem nur geringen Reflexionsgrad als auch Störstellen mit einem hohen Reflexionsgrad bis hin zur Totalreflexion erfasst.

Im Rahmen des Messzykluses mit den mehreren Einzelmessungen wird bei jeder Einzelmessung das Messsignal eingespeist und für verschiede, vorzugsweise für jede Einzelmessung wird der Schwellwert verändert. Aus der Vielzahl der Einzelmessungen ergibt sich daher eine Vielzahl von Stoppsignalen, die dann in das charakteristische Stoppmuster der zu überprüfenden Leitung einfließt und insbesondere das Stoppmuster bilden.

Die Variation des Schwellwertes beruht auch auf der Überlegung, dass einige charakteristische Störeffekte zu einer definierten Amplitude des reflektierten Anteils führen. Durch Erhöhen des Schwellwertes werden lediglich noch diejenigen Störstellen mit einer hohen reflektierten Signalamplitude erfasst.

Eine jeweilige Einzelmessung ist aufgrund des erfindungsgemäßen Messprinzips vorzugsweise beendet, sobald ein Stoppsignal ergangen ist. Um die Leitung auch zuverlässig darauf zu überprüfen, ob mehrere gleichartige Störstellen vorliegen, die jeweils zu einem reflektierten Anteil mit vergleichbarer Signalamplitude führen, wird weiterhin nach einer ersten Einzelmessung eine Messtotzeit vorgegeben, während derer die Messanordnung quasi deaktiviert ist und nicht auf ein Stoppsignal reagiert. Speziell ist dabei vorgesehen, dass nach einer ersten Einzelmessung und einem erfassten ersten Stoppsignal eine zweite Einzelmessung vorgenommen wird, bei der vorzugsweise der gleiche Schwellwert wie bei der ersten Einzelmessung eingestellt ist. Die Messtotzeit, innerhalb derer keine Erfassung eines Stoppsignals erfolgt, ist dabei (geringfügig) größer als die bei der ersten Einzelmessung erfasste Laufzeit zwischen dem Start- und dem Stoppsignal. Dadurch wird vermieden, dass der dem ersten Stoppsignal zugeordnete reflektierte Anteil bei der zweiten Einzelmessung erfasst wird. Dieser Zyklus wird vorzugsweise mehrfach wiederholt, bis kein weiteres Stoppsignal mehr erfasst wird. Dass heißt, die Messtotzeit wird jeweils an die Laufzeit des bei der vorhergehenden Einzelmessung erfassten (ersten, zweiten, dritten etc.) Stoppsignals angepasst, also geringfügig größer gewählt, bis zu diesem eingestellten Schwellwert kein weiteres Stoppsignal mehr ergeht.

Insgesamt wird durch geeignete Einstellung der jeweiligen Messtotzeit in Kombination mit einer Variation des Schwellwerts ein Signalverlauf ausgemessen. Insbesondere werden hierdurch auch abfallende Flanken im Signalverlauf erfasst. Signalpeaks mit an- sowie mit abfallenden Flanken lassen sich daher erfassen und auswerten.

Durch die Vielzahl der Einzelmessungen werden daher allgemein zu unterschiedlichen definierten Schwellwerten die Laufzeiten (Stoppsignale) der reflektierten Anteile erfasst. Insofern kann dieses Verfahren als ein spannungsdiskretes Zeitmessverfahren angesehen werden. Die Zahl der Einzelmessungen liegt dabei bevorzugt über 10, weiter bevorzugt über 20 oder auch über 50 und beispielsweise bis zu 100 oder auch mehr Einzelmessungen.

Die eingespeisten Messsignale propagieren innerhalb des Messleiters typischerweise mit einer Geschwindigkeit zwischen 1 bis 2,5 10⁸ m/s. Bei den hier speziell interessierenden Leitungslängen beispielsweise im Kraftfahrzeugbereich von typischerweise 1 bis 20 Meter liegen daher die Laufzeiten für das Messsignal im Bereich von einigen Nanosekunden bis einige 10 Nanosekunden.

Um eine ausreichende Auflösung zu gewährleisten wird die Messtotzeit dabei zweckdienlicherweise um 0,1 bis 1 Nanosekunden (ns), vorzugsweise 0,5 ns größer gewählt als die zuvor erfasste Laufzeit des Stoppsignals.

Bevorzugt wird weiterhin durch die Variation des Schwellwertes eine sogenannte Auslöseschwelle ermittelt, anhand derer ein Maß für einen Wellenwiderstand bestimmt wird. Durch eine sukzessive Veränderung (Erhöhung) des Schwellwertes wird zumindest näherungsweise (in Abhängigkeit der Stufen des Schwellwertes) der Maximalwert für die Signalamplitude des reflektierten Anteils erfasst. Da die Signalamplitude ein Maß für die Höhe des Wellenwiderstands an der Störstelle ist, kann hieraus also die (absolute) Größe des Wellenwiederstands ermittelt werden. Anhand der Auslöseschwelle wird dann auch ein Entscheidungskriterium ermittelt, ob die Leitung noch in einem ausreichend guten Zustand ist oder gegebenenfalls ausgetauscht werden muss. Neben einer absoluten Auswertung besteht wiederum die Möglichkeit der Auswertung durch Vergleich mit dem Referenzmuster, wobei dann beispielsweise in Abhängigkeit des Maßes einer Zunahme der Höhe der Signalamplitude des reflektierten Anteils entschieden wird, ob die Leitung noch gut ist.

Grundsätzlich besteht die Möglichkeit, ein vergleichsweise kurzes Messsignal nach Art eines Messimpulses in den Messleiter einzuspeisen und dann den reflektierten Anteil zu erfassen. Dies erfordert jedoch wiederum eine sehr genaue und hochpräzise Einspeise - sowie Messanordnung. Vorzugsweise ist daher vorgesehen, dass das eingespeiste Messsignal eine Signaldauer aufweist, die mindestens der zweifachen Signallaufzeit des Messsignals durch die Leitung mit der definierten Leitungslänge entspricht, sodass eine Überlagerung des Messsignals mit dem reflektierten Anteil erfolgt. Entsprechend liegt der Schwellwert auch oberhalb der Spannung des Messsignals. Gemäß einer alternativen Variante liegt der Schwellwert auch unterhalb der Spannung des Messsignals.

Die Signaldauer des Messsignals entspricht dabei vorzugsweise einer Frequenz im kHz-Bereich und insbesondere MHz-Bereich, und liegt beispielsweise bei maximal etwa 8 MHz. Für das Messprinzip ist die Dauer des Messsignals nicht entscheidend. Allerding führt eine hohe Signaldauer bei der Durchführung des Messzyklus zu einer Erhöhung der Gesamtmessdauer bei der Vermessung der Leitung. Bevorzugt wird eine Vielzahl von Einzelmessungen, beispielsweise mehr als 10, mehr als 20, mehr als 50 oder auch mehr als 100 Einzelmessungen für einen Messzyklus durchgeführt. Von daher wird vorzugsweise die Signaldauer im MHz-Bereich, speziell im Bereich von 1 bis 10 MHz gewählt.

In bevorzugter Ausgestaltung wird die Signaldauer des Messsignals bei verschiedenen Einzelmessungen unterschiedlich eingestellt. Speziell wird die Signaldauer an die Laufzeit bis zum Eintreffen des reflektierten Anteils angepasst, d.h. die Signaldauer wird in Abhängigkeit der Laufzeit des reflektierten Anteils eingestellt und entspricht beispielsweise zumindest dieser Laufzeit oder ist geringfügig (+10%) größer als diese. Bevorzugt wird die Einspeisung des Messsignals durch die Steuerung aktiv beendet, sobald das Stoppsignal erfasst wird. Diese Anpassung und Varianz der Signaldauer des Messsignals begünstigt eine Beschleunigung des Messzykluses, d.h. eine Reduzierung der Gesamtmessdauer.

Das Messsignal weist allgemein eine bekannte Geometrie auf und ist insbesondere als ein Rechtecksignal ausgebildet. Zweckdienlicher Weise zeigt dieses dabei eine sehr steil ansteigende Anstiegsflanke, um ein möglichst definiertes Messergebnis zu erzielen. Unter möglichst steil wird hierbei insbesondere verstanden, dass der Anstieg von 10 % auf 90 % der Amplitude des Messsignals innerhalb von maximal 2000 ps (Pikosekunden) vorzugsweise von maximal 100 ps erfolgt.

Wie zuvor bereits erläutert, wird eine Vielzahl von Einzelmessungen im Rahmen eines Messzykluses zur Vermessung des Leiters durchgeführt. Bevorzugt wird aus der Vielzahl dieser Einzelmessungen eine Vielzahl von Stoppsignalen ermittelt, die zeitlich verteilt angeordnet sind. Die Vielzahl der Stoppsignale gibt daher näherungsweise den tatsächlichen Signalverlauf des eingespeisten Messsignals und der reflektierten Anteile wieder. Zweckdienlicher Weise wird aus diesen Stoppsignalen der tatsächliche Signalverlauf für ein eingespeistes und am Leistungsende reflektiertes Messsignal beispielsweise durch einen mathematischen Kurvenfit approximiert.

Der approximierte Signalverlauf wird dabei vorzugsweise auch visualisiert, um einen visuellen Vergleich mit einem ebenfalls approximierten Signalverlauf des Referenzmusters zu ermöglichen.

Bei der Vielzahl von Einzelmessungen wird allgemein derart vorgegangen, dass der Schwellwert sukzessive variiert wird, wobei vorzugsweise unterschiedliche Schwellwert-Stufen eingestellt werden. Je feiner die Stufen, desto exakter lässt sich der Verlauf approximieren. Die Stufen zwischen zwei aufeinander folgenden Schwellwerten werden dabei vorzugsweise adaptiv beispielsweise in Abhängigkeit der zuvor erfassten Messergebnisse angepasst. Wird beispielsweise ein Stoppsignal erfasst, so werden möglichst kleine Stufen zum nächsten Schwellwert eingestellt (zunehmend / abnehmend) bis ein die jeweilige Störstelle beschreibender Signalpeak erreicht ist oder wieder abgeklungen ist.

Weiterhin wird in bevorzugter Ausgestaltung anhand der Laufzeit für das Stoppsignal auf einen Ort einer Störstelle zurückgeschlossen. Allgemein wird daher auch eine Ortsauswertung im Hinblick auf die Störstelle und damit ein ortsaufgelöstes Stoppmuster erzeugt beziehungsweise ausgewertet.

Insbesondere um eine möglichst hohe Ortsauflösung zu erzielen weist die Messanordnung allgemein eine hohe Zeitauflösung auf. Diese liegt vorzugsweise bei kleiner 100 ps und vorzugsweise bei etwa 50 ps. D.h. zwei Ereignisse, die zeitlich mehr als diese Zeitauflösung voneinander beabstandet sind, werden als getrennte Ereignisse erfasst und ausgewertet.

In zweckdienlicher Ausgestaltung wird ein Zeitmuster (Stopp-Zeitmuster) mit mehreren Zeilen generiert, wobei in jeder Zeile die Laufzeiten von Stoppsignalen eines definierten (festen) Schwellwertes hinterlegt sind, wobei der definierte Schwellwerte von Zeile zu Zeile variiert. Anhand dieses Zeitmusters kann daher sofort identifiziert werden, welcher Schwellwert zu welchem Zeitpunkt überschritten wird, sodass sofort erkannt wird, an welcher Position sich welche Störstellen befinden.

Speziell wird auch für das Referenzmuster ein derartiges Zeitmuster (Referenz-Zeitmuster) hinterlegt, sodass sehr einfach Verschiebungen durch Vergleich mit dem Stopp-Zeitmuster erkannt und ausgewertet werden können. Bei dem jeweiligen Zeitmuster handelt es sich daher insbesondere um eine zweidimensionale Matrix. Die Spalten geben unterschiedliche Laufzeiten und die Zeilen unterschiedliche Schwellwerte an.

Im Hinblick auf einen möglichst einfachen Vergleich zwischen dem Referenzmuster und dem Stoppmuster ist allgemein vorgesehen, dass das Referenzmuster anhand der Leitung in einem Ausgangszustand im Rahmen einer Referenz-Vermessung erfasst wird. Auch hier ist - wie beim Stoppmuster - insbesondere die Durchführung eines vorgegebenen Messzykluses mit einer Vielzahl (mehr als 10, mehr als 20, mehr als 50 oder mehr als 100) von Einzelmessungen vorgesehen. Bei dieser Referenz-Vermessung lässt sich daher insgesamt der Signalverlauf der Leitung im Ausgangszustand erfassen. Unter Ausgangszustand wird dabei ein konfektionierter Zustand der Leitung oder auch der in einer Anlage oder Komponente eingebaute Zustand der Leitung verstanden. Dies beruht auf der Überlegung, dass bei der Konfektionierung, also bei der Befestigung von Steckern oder dem Anschluss an einer Komponente, typischerweise bereits ursprüngliche Störstellen erzeugt werden. Dies können Knick- oder Biegestellen durch einen ungünstigen Verlauf der Leitung oder auch durch Klemmstellen im Bereich des Steckers sein. Bei einem ordnungsgemäßen Anschluss sind diese ursprünglichen Störstellen im Normal- oder Ausgangszustand jedoch für den normalen Betrieb der Leitung unkritisch. Durch Vermessung der Leitung im Normal- oder Ausgangszustand und der späteren Vermessung der Leitung nach einer gewissen Betriebsdauer wird daher in einfacher Weise erkannt, ob und inwieweit bereits eine Veränderung des Zustands der Leitung stattgefunden hat. Durch diese Maßnahme wird insbesondere auch eine Prognose ermöglicht und auch vorgenommen im Hinblick auf eine mögliche Ausfallzeit der Leitung, beziehungsweise eine Rest-Lebensdauer. Durch diese Maßnahme kann daher frühzeitig auf einen sich abzeichnenden Defekt reagiert und die Leitung bei Bedarf beispielsweise ausgetauscht werden.

Die Vermessung der Leitung erfolgt dabei wiederkehrend, insbesondere periodisch wiederkehrend. Je nach Anwendung liegen zwischen den Messungen Sekunden, Minuten, Stunden, Tage oder auch Monate. Im Kraftfahrzeugbereich kann beispielsweise eine Überprüfung jeweils im Rahmen einer routinemäßigen Inspektion vorgenommen werden.

Bevorzugt ist das Referenzmuster in verschlüsselter, codierter Form hinterlegt. Durch diese Maßnahme ist sichergestellt, dass lediglich Befugte, die in Kenntnis der Codierung sind, die Überprüfung und Auswertung der Leitung vornehmen können.

Zweckdienlicherweise wird das Verfahren zur Überwachung der Leitung auf eine Temperaturbelastung oder Temperatur-Überlastung eingesetzt. Hierzu ist der Messleiter von einer Isolierung (Dielektrikum) mit einer temperaturabhängigen Dielektrizitätszahl umgeben. Hierbei handelt es sich insbesondere um ein spezielles PVC oder auch um ein FRNC Material (Flame retardant non corrosive material). Isoliermaterialien mit einer temperaturabhängigen Dielektrizitätszahl sind bekannt. Aufgrund der Temperaturabhängigkeit führt eine Temperaturveränderung zu einer veränderten Laufzeit des reflektierten Anteils, sodass die Laufzeit des erfassten Stoppsignals im Vergleich zu der Referenzdauer des Referenzmusters verschoben ist. Aus dieser zeitlichen Verschiebung wird allgemein auf eine veränderte Temperaturbelastung geschlossen. Üblicherweise wird das Referenzmuster bei einer Umgebungstemperatur von beispielsweise 20° C erfasst. Zur Ermittlung einer über die Leitungslänge gemittelten Temperatur ist die Bestimmung der Laufzeit eines reflektierten Anteils ausreichend, das am Leitungsendes oder an einer örtlich definierten, bekannten Störstelle reflektiert wird.

Weiterhin wird aus dem Maß der zeitlichen Verschiebung auf ein Maß für die veränderte Temperaturbelastung geschlossen. Hieraus kann wiederum auf die absolute aktuelle Temperatur zurückgeschlossen werden. Wird ein vorgegebener Temperaturwert überschritten, wird dies als Überlastung der Leitung identifiziert. Bevorzugt erfolgt jedoch ein Vergleich mit dem Referenzmuster und es wird aus der relativen Verschiebung auf eine ggf. unzulässige Temperaturbelastung zurückgeschlossen.

In bevorzugter Weiterbildung wird mittels des Verfahrens eine äußere Zustandsgröße außerhalb der Leitung ermittelt, insbesondere deren Wert bestimmt, wobei sich die äußere Zustandsgröße entlang der Leitung verändert. Dies beruht auf der Überlegung, dass sich entlang der Leitung variierende äußere Zustandsgrößen als Störgrößen bemerkbar machen und dadurch quasi Störstellen bilden, die mittels des Verfahrens ebenso erfassbar sind. Die Zustandsgröße ist beispielsweise die Temperatur oder auch ein Wechsel in dem umgebenden Medium, beispielsweise ein Zustandswechsel insbesondere von gasförmig nach flüssig.

Bevorzugt wird die Leitung mit dem speziellen Messverfahren als Sensor, insbesondere als Füllstandssensor eingesetzt. Insbesondere in Kombination mit der Ortsauflösung ist nämlich eine genaue Bestimmung der Füllstandshöhe ermöglicht.

Alternativ ist die Leitung als Temperatursensor ausgebildet und beispielsweise innerhalb einer zu überwachenden Vorrichtung verlegt, wobei insbesondere eine ortsaufgelöste Temperaturbestimmung vorgenommen wird. So können beispielsweise innerhalb der Vorrichtung Bereiche mit unterschiedlichen Temperaturen ermittelt oder überwacht werden.

Zur Durchführung des Verfahrens ist erfindungsgemäß eine Messanordnung mit einer Messeinheit vorgesehen, welche zur Durchführung des Verfahrens ausgebildet ist. Gemäß einer ersten Ausführungsvariante ist die Messeinheit unmittelbar in der konfektionierten Leitung integriert, also beispielsweise in einem Stecker der Leitung oder auch unmittelbar in der Leitung. Alternativ hierzu ist gemäß einer zweiten Variante die Messeinheit in einer Steuereinheit eines Bordnetzes beispielsweise eines Kraftfahrzeugs integriert. In einer dritten Variante ist die Messeinheit schließlich in einem externen, beispielsweise handgeführten Messgerät integriert, wobei dieses reversibel an die zu überprüfende Leitung anschließbar ist.

Die Messeinheit umfasst dabei in zweckdienlicher Ausgestaltung einen Mikrocontroler, einen einstellbaren Komparator, einen Signalgenerator sowie ein Zeitmesselement. Bei der Messeinheit handelt es sich insbesondere um eine digitale, mikroelektronische Schaltung, die beispielsweise auf einen Mikrochip integriert ist. Aufgrund der Einfachheit lässt sich ein derartiger Mikrochip als Messeinheit in großen Stückzahlen und zu geringen Kosten erzeugen. Die Messeinheit lässt sich auch unmittelbar in die Leitung integrieren oder innerhalb eines Steckers. Die Messeinheit beziehungsweise der Mikrochip ist weiterhin bevorzugt zur Abgabe eines Warnsignals ausgebildet und / oder mit einer übergeordneten Auswerteeinheit verbunden. Weiterhin weist die Messeinheit und/oder die übergeordnete Auswerteeinheit bevorzugt auch einen Speicher zur Abspeicherung der erfassten Messwerte auf.

Der variable Schwellwert wird dabei mit Hilfe der Messeinheit insbesondere über den Mikrocontroler eingestellt und auch automatisch variiert. Zweckdienlicher Weise ist dabei der Mikrocontroler allgemein zur automatischen Durchführung des zuvor beschriebenen Messzykluses eingerichtet.

Ein Ausführungsbeispiel der Erfindung wird nachfolgend anhand der Figuren näher erläutert. Diese zeigen
- Fig. 1: eine vereinfachte Darstellung einer Messanordnung mit einer Messeinheit und einer zu überwachenden Leitung,
- Fig. 2: ein Blockschaltbild der Messeinheit zur Erläuterung des Verfahrens,
- Fig. 3A-3C: Darstellungen des Signalverlaufs für unterschiedliche Situationen,
- Fig. 4A, 4B: ein Spannungs-Zeit-Diagramm mit einer Referenzkurve sowie ein zugeordnetes Referenzmuster (Fig. 4B),
- Fig. 5A, 5B: ein Spannungs-Zeit-Diagramm einer ersten Messkurve sowie ein zugeordnetes Stoppmuster (Fig. 5B),
- Fig. 6A, 6B: ein Spannungs-Zeit-Diagramm einer zweiten Messkurve sowie ein zugeordnetes Stoppmuster (Fig. 6B) sowie
- Fig. 7A, 7B: eine Gegenüberstellung eines Stopp-Zeitmusters gegenüber einem Referenz-Zeitmusters.

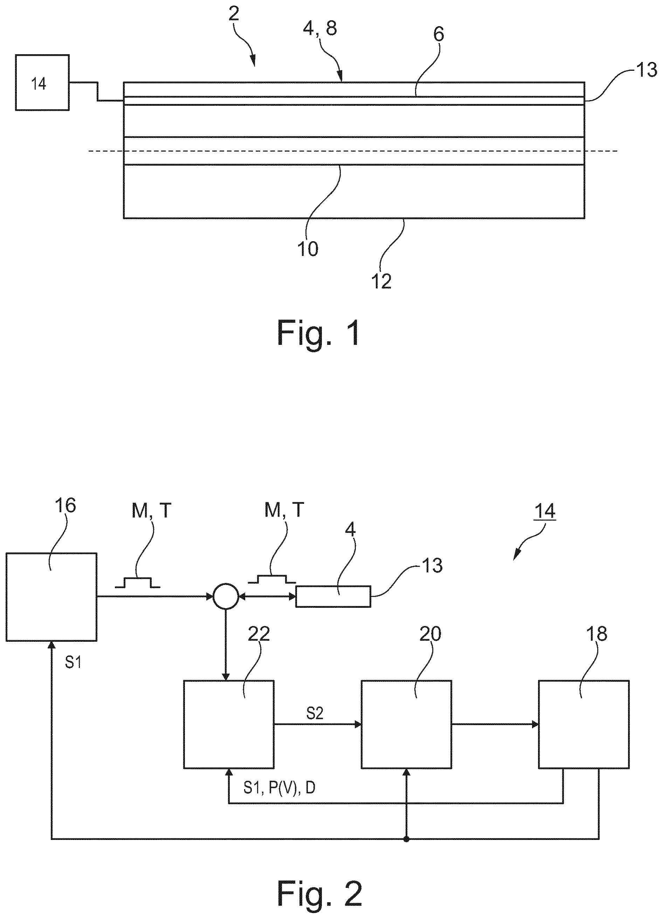

In Fig. 1 ist eine Messanordnung 2 dargestellt. Diese weist eine Leitung 4 auf, welche wiederum einen Messleiter 6 aufweist, welcher sich in Längsrichtung entlang der Leitung 4 insbesondere über deren gesamte Länge erstreckt. Die Leitung 4 ist im gezeigten Ausführungsbeispiel eine einfache einadrige Leitung 4, weist also eine Ader 8 mit einen zentralen Leiter 10 auf, welcher von einer Isolierung 12 umgeben ist. In diese Isolierung 12 ist der Messleiter 6 eingebettet. Grundsätzlich sind auch andere Aufbauten möglich. Beispielsweise wird der zentrale Leiter 10 selbst als Messleiter herangezogen. Alternativ handelt es sich bei dem Messleiter 6 um einen Innenleiter einer Koaxialleitung. In diesem Fall ist der Messleiter von einer ein Dielektrikum umgebenen Isolierung sowie einem beispielsweise als Geflecht ausgebildeten Außenleiter umgeben. Dem Messleiter 6 ist allgemein ein Rückleiter zugeordnet, welcher in den Figuren nicht explizit dargestellt ist. Bei diesem handelt es sich beispielsweise um den Außenleiter einer Koaxialleitung. Alternativ sind Messleiter 6 und Rückleiter beispielsweise durch ein Adernpaar gebildet.

Der Messleiter 6 ist zusammen mit dem Rückleiter an einer Messeinheit 14 angeschlossen, sodass die Leitung 4 hinsichtlich einer Abweichung von einem Normalzustand überwacht werden kann. Beispiele für eine solche Abweichung sind eine übermäßige Erwärmung der Leitung 4 über eine vorgegebene Betriebstemperatur hinaus und/ oder eine Beschädigung, beispielsweise ein Bruch des Außenleiters beispielsweise in Folge eines übermäßigen Verbiegens der Leitung 4. Die Belastungen der Leitung 4 erfährt auch der Messleiter 6.

FIG 2 zeigt eine vereinfachte Blockbild-Darstellung der Messeinheit 14 und dient zur Erläuterung des Verfahrens. Die Messeinheit 14 umfasst einen Signalgenerator 16, einen Mikrocontroler 18, ein Zeitmesselement 20 sowie einen einstellbaren Komparator 22. Der Mikrocontroler 18 dient zur Steuerung und Durchführung des Verfahrens. So gibt der Mikrocontroler 18 ein Startsignal S1 zur Durchführung einer jeweiligen Einzelmessung ab. Dieses Startsignal S1 wird sowohl an den Signalgenerator 16 als auch an das Zeitmesselement 20 übermittelt. Weiterhin übermittelt der Mikrocontroler 18 ein Einstellsignal P, über das ein Spannungsschwellwert V vorgegeben und am Komparator 22 eingestellt wird.

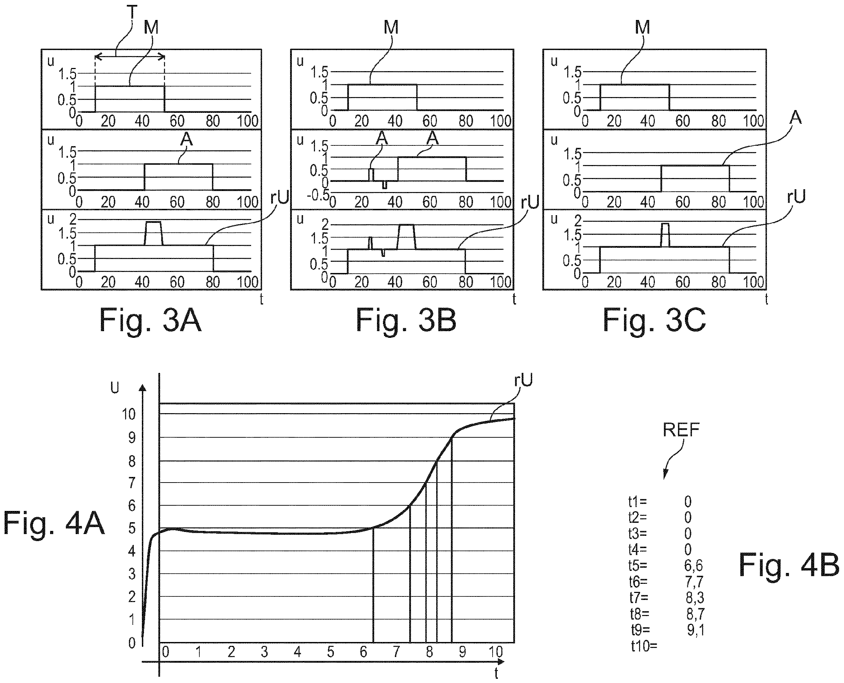

Nach dem Startsignal S1 erzeugt der Signalgenerator 16 ein Messsignal M, insbesondere ein Rechtecksignal, welches eine vorgegebene Zeitdauer T aufweist. Dieses Messsignal M wird an einem Einspeiseort 24 in die Leitung 4 eingespeist. Innerhalb der Leitung 4 propagiert das Messsignal M in Richtung zu einem Leitungsende 13, an dem der Messleiter 6 offen ausgebildet ist. Hierdurch wird das Messsignal M am Leitungsende 13 reflektiert. Der reflektierte Anteil A (vgl. Fig. 3A-3C) läuft in entgegengesetzter Richtung wieder zum Einspeiseort 24.

Der Einspeiseort 24 ist im Ausführungsbeispiel zugleich ein Messort 25, an dem der am Messleiter 6 anliegende Signalpegel (Spannungspegel) abgegriffen wird. Mittels des Komparators 22 wird hierbei jedoch lediglich überprüft, ob der Signalpegel den vorgegebenen Schwellwert V übersteigt (übersteigen bzw. unterschreiten im engeren Sinn). Sobald der Komparator erfasst, dass der Schwellwert V überschritten ist, gibt der Komparator 22 ein Stoppsignal S2 an das Zeitmesselement 20 ab. Dieses ermittelt daraufhin die Zeitdifferenz zwischen dem Startsignal S1 und dem Stoppsignal S2 und übermittelt diese Differenz als erfasste Laufzeit t für den reflektierten Anteil A. Bei dieser Einzelmessung wird zunächst lediglich ein einzelnes Messsignal M eingespeist und der reflektierte Anteil A ausgewertet. Es erfolgt keine Einspeisung von mehreren Messsignalen während der Einzelmessung.

Nach erfolgter Einzelmessung wiederholt der Mikrocontroler 18 die Messung. Hierzu variiert er den Schwellwert V, insbesondere sofern zuvor kein Stoppsignal S2 erging. In einem solchen Fall (kein Stoppsignal) bricht die Messeinheit 14 nach einer vorgegebenen Maximal-Messzeit die Einzelmessung ab.

Für den Fall, dass ein Stoppsignal S2 erging, legt der Mikrocontroler 18 eine Messtotzeit D fest und übermittelt diese beispielsweise an den Komparator 22 oder auch an das Zeitmesselement 20. Die Messtotzeit D liegt typischerweise bei einigen 10 ps oberhalb der zuvor erfassten Laufzeit t. Während dieser Messtotzeit D ignoriert das Zeitmesselement 20 eventuell eingehende Stoppsignale S2, bzw. der Komparator 22 erzeugt kein Stoppsignal S2.

Die Einstellung der Messtotzeit erfolgt vorzugsweise durch eine Beaufschlagung des Komparators 22 mit einem zusätzlichen Sperrsignal, insbesondere an einem sogenannten latch-Eingang, welches dazu führt, dass der Komparator für die Dauer des anliegenden Sperrsignals deaktiv ist, also kein Ausgangssignal abgibt. Dieses Sperrsignal wird beispielsweise durch einen Mikrocontroller erzeugt. Vom Komparator 22 wird dabei bei einem Überschreiten des Schwellwerts V von unten als auch von oben das Stoppsignal S2 abgegeben. Liegt also zu Beginn der Auswertung oder nach der Messtotzeit D bereits ein Spannungswert oberhalb der Schwelle V an, so gibt der Komparator 22 das Stoppsignal S2 erst bei einem Unterschreiten der Schwelle V ab. Dadurch lassen sich insbesondere auch abfallende Flanken des Signalpegels erfassen und auswerten.

Der Komparator 22 weist vorzugsweise zwei Zustände (1 und 0) auf, die jeweils angeben, ob der aktuelle Spannungswert oberhalb oder unterhalb des Schwellwerts liegt. Bei einer Zustandsänderung (Wechsel von 1 auf 0 oder von 0 auf 1) wird also das Stoppsignal S2 abgegeben. Der Zustand des Komparators 22 ist vorzugsweise ebenfalls auswertbar, so dass z.B. unmittelbar erkennbar ist, ob zu Beginn der Messung bereits die anliegende Spannung oberhalb (oder unterhalb) des Schwellwerts V ist.

Anhand der Fig. 3A bis 3C wird nachfolgend der Signalverlauf, also der tatsächliche Spannungsverlauf am Messort 25, für unterschiedliche Situationen illustriert. Fig. 3A zeigt dabei den Signalverlauf einer Leitung im Normalfall (Referenz), Fig. 3B den Signalverlauf im Falle beispielsweise einer Knickstelle als Störstelle und Fig. 3C den Signalverlauf bei einer veränderten Temperaturbelastung.

In allen drei Figuren ist jeweils im oberen Teilbild das eingespeiste Messsignal M als schematisiertes Rechtsecksignal mit vorgegebener Signaldauer T dargestellt. Im mittleren Teilbild ist jeweils der reflektierte Anteil A dargestellt und im unteren Teilbild die am Messort 25 anliegende überlagerte Spannung zwischen dem Messsignal M und dem reflektierten Anteil A. Am Messort 25 wird also ein resultierender Signalverlauf rU durch Überlagerung des Messsignals M mit dem reflektierten Anteil A erhalten. In den Fig. 3A, 3B ist dabei jeweils die Spannung U gegenüber der Laufzeit t in normierten Einheiten angegeben.

Wie anhand der Fig. 3B gut zu erkennen ist, ist die Signaldauer T derart bemessen, dass am Messort 25 eine Überlagerung des Messsignals M mit dem reflektierten Anteil A erfolgt. Der resultierende Signalverlauf rU weist daher (bei Vernachlässigung der Dämpfung) für einen gewissen Zeitbereich die zweifache Spannung des Messsignals M auf.

Im Falle einer Störstelle, wie dies in Fig. 3B dargestellt ist, wird ein zusätzlicher Signalanteil bei einer kürzeren Laufzeit T reflektiert. Diese zusätzlichen reflektierten Anteile A sind innerhalb des überlagerten Signalverlaufs rU ebenfalls gut zu erkennen.

Eine veränderte Temperatur führt allgemein zu einer unterschiedlichen Signallaufzeit des Messsignals M. Da der Messleiter 16 am Ende offen ist und damit eine Reflektion am Ende stattfindet, verändert sich die Laufzeit t in Abhängigkeit der Temperatur in charakteristischer Weise, was zu einer Verschiebung des reflektierten Anteils A im Vergleich zu der in Fig. 3A dargestellten Referenz führt. Anhand dieser Verschiebung kann auf das tatsächliche Maß der Temperaturänderung zurückgeschlossen werden.

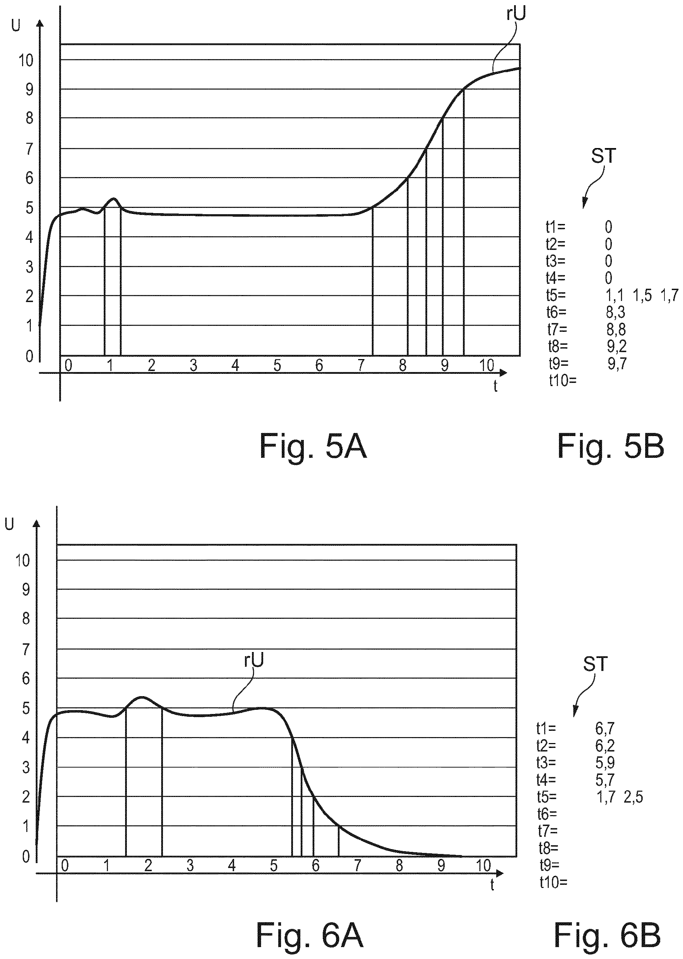

Die Fig. 4A, 5A, 6A zeigen resultierende, überlagerte Signalverläufe rU am Messort 24 in einer mehr realistischen Darstellung. Fig. 4A zeigt dabei den überlagerten Signalverlauf rU im Normalzustand, also bei einer Referenzmessung. Fig. 5A zeigt den überlagerten Signalverlauf rU bei einer zusätzlichen Störstelle sowie eine Temperaturerhöhung. Fig. 6A zeigt schließlich den überlagerten Signalverlauf rU bei einer zusätzlichen Störstelle und ergänzend einem Kurzschluss. Die Störstelle ist beispielsweise ein Bruch oder eine Beschädigung im Bereich des Messleiters 6, wodurch sich allgemein der Wellenwiderstand verändert und zur Reflektion führt.

Für jede diese drei Situationen wird die Leitung 4 jeweils im Rahmen eines Messzykluses vermessen. Bei diesem werden sukzessive die Schwellwerte V angehoben und die Laufzeiten t für einen jeweiligen zugeordneten Schwellwert V erfasst. In den Ausführungsbeispielen der Fig. 4A, 5A, 6A ist die Spannung in normierten Einheiten angegeben. Der Wert 1 entspricht beispielsweise 1 Volt oder auch 100 mV. Die Amplitude des eingespeisten Messsignals (Spannungssprung) liegt bevorzugt bei 1V.Die Schwellwerte werden beispielsweise jeweils in Schritten von 10% bis 20% der Amplitude des eingespeisten Messsignals erhöht. Die Auslösezeiten zu den zugeordneten Schwellwerten V, wenn also ein Auslösen des Komparators 22 durch Abgabe eines Stoppsignals S2 erfolgt, sind jeweils durch vertikale Linien gekennzeichnet. Anhand der Mehrzahl von Einzelmessungen, vorliegen sind beispielsweise Einzelmessungen bei insgesamt 10 Schwellwerten durchgeführt, wird ein Referenzmuster REF beispielsweise gemäß Fig. 4B beziehungsweise ein Stoppmuster ST beispielsweise gemäß den Fig. 5B oder 6B erzeugt. Dabei wird zu jedem Schwellwert V die Zeit (in Nanosekunden ns) erfasst, wenn der jeweilige Schwellwert V überschritten ist. Die Ziffer t1 steht hier für die Laufzeit t bis der Schwellwert "1" überschritten ist, die Ziffer t2 für Zeitdauer t bis der Schwellwert "2" überschritten ist etc.

Bei den überlagerten Signalverläufen rU mit den zusätzlichen Störstellen ist ein zusätzlicher Signalpeak mit einer aufsteigenden sowie absteigenden Flanke erkennbar.

Vorzugsweise ist allgemein vorgesehen, dass die Auflösung, also der Abstand der Schwellwerte zueinander in unterschiedlichen Spannungsbereichen unterschiedlich eingestellt wird. Beispielsweise wird in ersten Bereichen, die z.B. einen auffallenden Signalverlauf zeigen, beispielsweise im Bereich des Signalpeaks, die Auflösung durch eine Verringerung des Abstands zwischen den Schwellwerten V erhöht. Im Ausführungsbeispiel werden beispielsweise im Spannungsbereich zwischen 4,5 und 5,5 die Schwellwerte V in kleineren Schritten eingestellt. Die Abstände zwischen aufeinanderfolgenden Schwellwerten liegen dabei beispielsweise unter 1, vorzugsweise unter 0,5 und weiter vorzugsweise unter 0,2, jeweils bezogen auf die normierte Einheit. Vorzugsweise werden umgekehrt in zweiten Bereichen eine geringere Auflösung durch höhere Abstände zwischen den Schwellwerten eingestellt. Im Ausführungsbeispiel betrifft dies z.B. die Spannungsbereiche zwischen 0 und 4,5 sowie zwischen 6 und 9. Die Abstände zwischen aufeinanderfolgenden Schwellwerten liegen dabei beispielsweise über 0,5, vorzugsweise über 1 oder vorzugsweise über 1,5, jeweils bezogen auf die normierten Einheiten. Die Auflösung wird dabei vorzugsweise über den Mikrocontroller 18 eingestellt.

Wie anhand der Fig. 4A, 4B zu erkennen ist, wird den ersten 4 Schwellwerten die Laufzeit 0 zugewiesen (t = 0), da der Signalpegel des überlagerten Signalverlaufs rU von Beginn über diesen (geringen) Schwellwerten V liegt. Aufgrund der Reflektion am Leitungsende 13 steigt nach einer definierten Signallaufzeit, die mit der Leitungslänge korreliert, der Spannungswert kontinuierlich auf etwa den zweifachen Wert der Spannung des Messsignals M an. Dies führt dazu, dass sukzessive mehrere Schwellwerte V zu unterschiedlichen Zeiten t5 bis t9 überschritten werden.

Die Referenz-Messwerte, insbesondere das Referenzmuster REF der Referenzmessung ist dabei vorzugsweise innerhalb eines hier nicht näher dargestellten Speichers der Messeinheit 14 hinterlegt oder alternativ auch an einem anderen Ort, beispielsweise einer übergeordneten Auswerteeinheit.

Das Stoppmuster gemäß der Fig. 5B zeigt zunächst ein gleiches Muster bei den geringen Schwellwerten V für die Spannungswerte 1 bis 4. Der Wert 5 wird jedoch mehrfach, nämlich zu den Zeitdauern t5 = 1,1 ns; 1,5 ns sowie 7,5 ns überschritten. Hierdurch ist erkennbar, dass bei einer Laufzeit t zwischen 1,1 und 1,5 ns ein reflektierter Anteil A vorliegt, der auf eine Störstelle zurückzuführen ist. Diese war zuvor beim Referenzmuster REF nicht zu erkennen. Insofern ist nunmehr anhand eines Vergleiches des Stoppmusters ST mit dem Referenzmuster REF bereits unmittelbar erkennbar, dass die Leitung 4 im Laufe des Betriebes beschädigt wurde. Je nach Grad der Beschädigung entscheidet dann der Mikrocontroler 18, ob und in wie weit ein Warnsignal abgegeben wird.

Weiterhin ist zu erkennen, dass sich die Laufzeiten t6 bis t9 für den am Leitungsende 13 reflektierten Signalanteil A hin zu längeren Laufzeiten t verschoben haben. Anhand dieser Verschiebung ist zusätzlich auf eine veränderte, insbesondere erhöhte Temperaturbelastung der Leitung 4 zu schließen. In Abhängigkeit der Verschiebung entscheidet wiederum der Mikrocontroler 18, ob und in wie weit ein Warnsignal abgegeben wird.

Bei der in der Fig. 6A dargestellten Situation erfolgt aufgrund des Kurzschlusses keine Reflektion am Leitungsende 13. Dies ist daran erkennbar, dass für höhere Schwellwerte V kein reflektierter Anteil A mehr erfassbar ist.

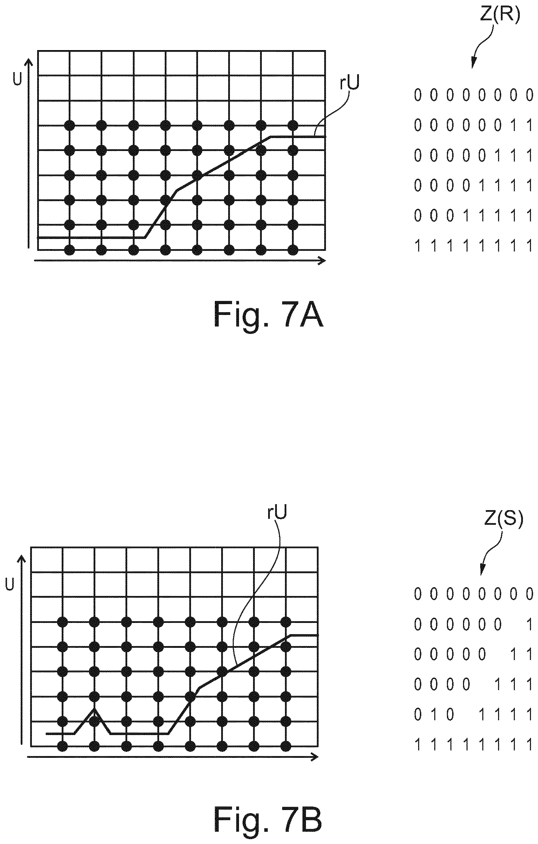

Die Ergebnisse eines Messzykluses können grundsätzlich auch innerhalb eines Matrixförmigen Zeitmusters Z abgelegt werden, wie dies anhand eines Referenz-Zeitmusters Z(R) für das Referenzmuster REF und anhand eines Stopp-Zeitmusters Z(S) für ein Stoppmuster ST in den Fig. 7A, 7B dargestellt ist. Die linke Bildhälfte zeigt dabei jeweils wiederum den überlagerten Signalverlauf rU im Spannungs-Zeitdiagramm. Im jeweiligen Zeitmuster Z entspricht eine jeweilige Zeile jeweils einem festen Schwellwert V und eine jeweilige Spalte ist entweder einer definierten Laufzeit t zugeordnet oder in einer jeweiligen Spalte (beziehungsweise Zelle) ist der tatsächliche gemessene Wert für die Laufzeit t des jeweiligen Stoppsignals S2 angeführt. In den Fig. 7A, 7B sind die Zeitmuster Z beispielhaft als Bit-Muster mit Nullen und Einsen dargestellt. In diesem Fall entspricht daher eine jeweilige Spalte lediglich einer fest vorgegebenen Laufzeit t (Zeitfenster). Anhand des Zeitmusters Z(REF) für die Referenz kann der typische überlagerte Signalverlauf rU nachvollzogen werden.

Durch ein Vergleich des Zeitmusters Z(R) für das Referenzmuster REF mit dem Zeitmuster Z(S) für das Stoppmuster St gemäß der Fig. 7B ist dabei gut zu erkennen, dass eine Veränderung stattgefunden hat. Zum einen ist beim zweiten Spannungsschwellwert V (2. Zeile) und der zweiten Spalte also in der Zelle [2; 1] nunmehr eine 1 an Stelle einer 0 enthalten. Auch sind die Zellen [4; 2], [5; 3], [6; 4], [9; 5] anders als bei den Zeitmuster Z(R) gemäß der Fig. 7A nicht belegt, was ebenfalls auf eine Verschiebung hindeutet. Diese beiden Zeitmuster Z(R), Z(S) werden beispielsweise durch Vergleich ausgewertet. Vorzugsweise wird anstelle eines Bitmusters ein Zeitmuster erstellt, bei dem die genauen Laufzeiten t festgehalten sind, wann die jeweilige Schwelle V über- bzw. unterschritten ist. Neben einer Erhöhung der Genauigkeit wird dabei auc323h das erforderliche Datenvolumen reduziert.

## Patentansprüche

1. Verfahren zur Überwachung einer Leitung die einen sich entlang der Leitung erstreckenden Messleiter aufweist, wobei
- in den Messleiter ein Messsignal zu einer Startzeit eingespeist wird,
- des Messsignal bei Vorliegen einer Störstelle an dieser zumindest teilweise reflektiert wird
- der Messleiter auf einen reflektierten Anteil überwacht wird, wobei bei Überschreiten eines Schwellwertes jeweils ein digitales Stoppsignal erzeugt wird und die Laufzeit zwischen der Startzeit und dem Stoppsignal erfasst und ausgewertet wird,
- im Rahmen eines Messzykluses mehrere Einzelmessungen durchgeführt werden und bei jeder Einzelmessung das Messsignal eingespeist wird, wobei für verschiedene Einzelmessungen der Schwellwert variiert wird
- durch eine Vielzahl von Einzelmessungen eine Vielzahl von Stoppsignalen mit unterschiedlichen Laufzeiten ermittelt wird, wobei zu jeder Einzelmessung der eingestellte Schwellwert und die zu diesem Schwellwert zugehörige Laufzeit als Wertepaar festgehalten werden und aus der Vielzahl der Wertepaare ein Signalverlauf ermittelt wird, wobei
- nach Erfassung eines ersten Stoppsignals bei einer ersten Einzelmessung eine zweite Einzelmessung mit vorzugsweise dem gleichen Schwellwert wie bei der ersten Einzelmessung vorgenommen wird, wobei bei der zweiten Einzelmessung eine Messtotzeit vorgegeben wird, die größer ist als die bei der ersten Einzelmessung erfasste Laufzeit für das erste Stoppsignal, so dass der dem ersten Stoppsignal zugeordnete reflektierte Anteil bei der zweiten Einzelmessung nicht erfasst wird und durch die Messtotzeit in Kombination mit der Variation des Schwellwertes ansteigende sowie abfallende Flanken im Signalverlauf erfasst werden, wobei zur Erfassung einer abfallenden Flanke ein Stoppsignal bei einem Unterschreiten des eingestellten Schwellwerts abgegeben wird
- die Leitung mehrere über ihre Leitungslänge verteilte Störstellen aufweist und jede Störstelle eine Teilreflektion des Messsignals erzeugt, sodass ein charakteristisches Muster gebildet wird und
- durch die Vielzahl der Stoppsignale ein die Leitung charakterisierendes Stoppmuster erzeugt wird, und das Stoppmuster mit einem Referenzmuster für einen Normalzustand der Leitung verglichen und auf eine Abweichung überprüft wird, wobei
- das Stoppmuster sowie das Referenzmuster mehrere reflektierte Anteile aufweisen, die jeweils durch eine der Störstellen erzeugt sind und das Stoppmuster sowie das Referenzmuster durch Stoppsignale mit unterschiedlichen Laufzeiten gebildet sind.

2. Verfahren nach Anspruch 1, bei dem ein Messzyklus mit mehreren aufeinanderfolgenden Einzelmessungen durchgeführt wird, so dass mehrere Stoppsignale mit unterschiedlichen Laufzeiten erhalten werden, wobei sich die mehreren Stoppsignale über einen Bereich erstrecken, der zumindest 10% einer maximalen Gesamtlaufzeit beträgt, die das Messsignal von einem Einspeiseort bis zu einem Leitungsende und zurück zum Einspeiseort benötigt.

3. Verfahren nach einem der Ansprüche 1 bis 2, bei dem der Schwellwert über einen Bereich variiert wird, der zumindest dem 0,5 fachen und bevorzugt zumindest dem 0,75 fachen der Amplitude des Messsignals entspricht.

4. Verfahren nach einem der Ansprüche 1 bis 3, wobei durch die Variation des Schwellwerts eine Auslöseschwelle ermittelt wird, anhand derer ein Maß für die Höhe eines Wellenwiderstands für das Messsignal bestimmt wird.

5. Verfahren nach einem der Ansprüche 1 bis 4 wobei das Messsignal eine Signaldauer aufweist, die mindestens einer zweifachen Signallaufzeit durch die Leitung entspricht, so dass eine Überlagerung des Messsignals mit dem reflektierten Anteil erfolgt.

6. Verfahren nach einem der Ansprüche 1 bis 5, bei dem eine Signaldauer des Messsignals für die Einzelmessungen variiert wird.

7. Verfahren nach einem der Ansprüche 1 bis 6, bei dem ein Zeitmuster mit mehreren Zeilen generiert wird, wobei in jeder Zeile die Laufzeiten von Stoppsignalen eines definierten, von Zeile zu Zeile unterschiedlichen Schwellwertes hinterlegt sind.

8. Verfahren nach einem der Ansprüche 1 bis 7, bei dem das Referenzmuster durch eine Referenzmessung anhand der Leitung in einem Ausgangszustand ermittelt wird, insbesondere nach deren Konfektion oder deren Einbau in einer Vorrichtung und das Stoppmuster nachfolgend während der Betriebszeit insbesondere wiederkehrend gemessen wird.

9. Verfahren nach einem der Ansprüche 1 bis 8, bei dem der Messleiter einen Leiter sowie eine diesen umgebende Isolierung mit einer temperaturabhängigen Dielektrizitätszahl aufweist, so dass eine Temperaturveränderung zu einer veränderten Laufzeit des reflektierten Anteils führt, die im Hinblick auf eine Temperaturbelastung ausgewertet wird, wobei vorzugsweise aus einer zeitlichen Verschiebung des Stoppsignals gegenüber einer Referenzdauer auf eine veränderte Temperaturbelastung geschlossen wird.

10. Verfahren nach dem Anspruch 9, bei dem das Maß der zeitlichen Verschiebung gemessen und hieraus ein Maß für die veränderte Temperaturbelastung ermittelt wird

11. Verfahren nach einem der Ansprüche 1 bis 10, bei dem eine äußere Zustandsgröße erfasst wird, insbesondere ein Füllstand, die sich entlang der Leitung verändert.

12. Messanordnung zur Überwachung einer Leitung, wobei die Leitung einen sich entlang der Leitung erstreckenden Messleiter aufweist, wobei die Messanordnung eine Messeinheit aufweist, und
wobei die Messeinheit dafür ausgebildet ist, an den Messleiter angeschlossen zu werden und dabei
- in den Messleiter ein Messsignal zu einer Startzeit einzuspeisen,
- einen an einer Störstelle reflektierten Anteil zu überwachen,
- bei Überschreiten eines Schwellwertes jeweils ein digitales Stoppsignal zu erzeugen
- die Laufzeit zwischen der Startzeit und dem Stoppsignal zu erfassen, wobei weiterhin die Messanordnung, insbesondere die Messeinheit dafür ausgebildet ist, die Laufzeit auszuwerten, sowie
- im Rahmen eines Messzykluses mehrere Einzelmessungen durchzuführen und bei jeder Einzelmessung das Messsignal einzuspeisen wird, wobei für verschiedene Einzelmessungen der Schwellwert variiert wird
- durch eine Vielzahl von Einzelmessungen eine Vielzahl von Stoppsignalen mit unterschiedlichen Laufzeiten zu ermitteln, wobei zu jeder Einzelmessung der eingestellte Schwellwert und die zu diesem Schwellwert zugehörige Laufzeit als Wertepaar festgehalten werden und aus der Vielzahl der Wertepaare ein Signalverlauf ermittelt wird, wobei
- nach Erfassung eines ersten Stoppsignals bei einer ersten Einzelmessung eine zweite Einzelmessung mit vorzugsweise dem gleichen Schwellwert wie bei der ersten Einzelmessung vorgenommen wird, wobei bei der zweiten Einzelmessung eine Messtotzeit vorgegeben wird, die größer ist als die bei der ersten Einzelmessung erfasste Laufzeit für das erste Stoppsignal, so dass der dem ersten Stoppsignal zugeordnete reflektierte Anteil bei der zweiten Einzelmessung nicht erfasst wird und durch die Messtotzeit in Kombination mit der Variation des Schwellwertes ansteigende sowie abfallende Flanken im Signalverlauf erfasst werden wobei zur Erfassung einer abfallenden Flanke ein Stoppsignal bei einem Unterschreiten des eingestellten Schwellwerts abgegeben wird,
- die Leitung mehrere Störstellen aufweist und jede Störstelle eine Teilreflektion des Messsignals erzeugt, sodass ein charakteristisches Muster gebildet wird und
- durch die Vielzahl der Stoppsignale ein die Leitung charakterisierendes Stoppmuster zu erzeugen, und das Stoppmuster mit einem Referenzmuster für einen Normalzustand der Leitung zu vergleichen und auf eine Abweichung zu überprüfen, wobei
- das Stoppmuster sowie das Referenzmuster mehrere reflektierte Anteile aufweisen, die jeweils durch eine der Störstellen erzeugt sind und das Stoppmuster sowie das Referenzmuster durch Stoppsignale mit unterschiedlichen Laufzeiten gebildet sind.

13. Messanordnung nach dem Anspruch 12, bei dem die Messeinheit in einem Stecker der Leitung oder einer Steuereinheit eines (Bord-) Netzes oder in einem Messgerät integriert ist.

## Claims

1. Method for monitoring a line, which comprises a measuring conductor extending along said line, wherein
- a measuring signal is fed into the measuring conductor at a starting time,
- in the presence of a disruption point, the measurement signal is at least partially reflected at the disruption point,
- the measuring conductor is monitored for a reflected portion, wherein, if a threshold value is exceeded, respectively a digital stop signal is generated and the transit time between the starting time and the stop signal is detected and evaluated,
- several individual measurements are carried out within a measurement cycle and the measurement signal is fed in at each individual measurement, wherein the threshold value is varied for different individual measurements,
- by means of a plurality of individual measurements, a plurality of stop signals with different transit times is determined, wherein at each individual measurement the set threshold value and the transit time associated with this threshold value are recorded as a value pair and a signal curve is determined from the plurality of value pairs, wherein
- after detection of a first stop signal in a first individual measurement, a second individual measurement with preferably the same threshold value as in the first individual measurement is carried out, wherein in the second individual measurement a measurement dead time is specified, which is greater than the transit time for the first stop signal detected in the first individual measurement, so that the reflected portion assigned to the first stop signal is not detected in the second individual measurement and by the measuring dead time in combination with the variation of the threshold value, rising as well as falling edges in the signal curve are detected, wherein for the detection of a falling edge a stop signal is emitted when the value falls below the set threshold,
- the line comprises several disruption points distributed over its length and each disruption point generates a partial reflection of the measurement signal, so that a characteristic pattern is formed, and
- by the plurality of stop signals a stop pattern characterizing the line is generated, and the stop pattern is compared with a reference pattern for a normal state of the line and checked for deviation, wherein
- the stop pattern and the reference pattern comprise several reflected portions, each of which is generated by one of the disruption points, and the stop pattern and the reference pattern are formed by stop signals with different transit times.

2. Method according to claim 1, in which a measuring cycle with several successive individual measurements is carried out, so that several stop signals with different transit times are obtained, wherein said several stop signals extend over a range, which is at least 10% of a maximum total transit time that the measuring signal requires to travel from a feeding location to a line end and back to the feeding location.

3. Method according to one of claims 1 to 2, in which the threshold value is varied over a range corresponding to at least 0.5 times and preferably at least 0.75 times the amplitude of the measurement signal.

4. Method according to one of claims 1 to 3, wherein by the variation of the threshold value a triggering threshold is determined, on the basis of which a measure for the magnitude of a characteristic impedance for the measurement signal is determined.

5. Method according to one of claims 1 to 4, wherein the measurement signal has a signal duration, which corresponds to at least twice a signal transit time through the line, so that the measurement signal is superimposed on the reflected portion.

6. Method according to one of claims 1 to 5, in which a signal duration of the measurement signal is varied for the individual measurements.

7. Method according to one of the claims 1 to 6, in which a time pattern with several lines is generated, wherein in each line the transit times of stop signals of a defined threshold value varying from line to line are stored.

8. Method according to one of claims 1 to 7, in which the reference pattern is determined by means of a reference measurement on the basis of the line in an initial state, in particular after its manufacture or its installation in a device, and the stop pattern is subsequently measured, in particular repeatedly, during the operating time.

9. Method according to one of claims 1 to 8, in which the measuring conductor comprises a conductor and an insulation surrounding said conductor with a temperature-dependent dielectric constant, so that a change in temperature leads to a changed transit time of the reflected portion, which is evaluated with regard to a temperature load, wherein a changed temperature load is preferably inferred from a time shift of the stop signal with respect to a reference duration.

10. Method according to claim 9, in which the extent of the time shift is measured and from this a measure of the changed temperature load is determined.

11. Method according to one of claims 1 to 10, in which an external condition variable is detected, in particular a filling level, which changes along the line.

12. Measuring arrangement for monitoring a line, wherein the line comprises a measuring conductor extending along the line, wherein the measuring arrangement comprises a measuring unit, and wherein the measuring unit is designed to be connected to the measuring conductor and thereby
- to feed a measuring signal into the measuring conductor at a starting time,
- to monitor a portion reflected at a disruption point,
- to generate a digital stop signal each time a threshold value is exceeded,
- to record the transit time between the starting time and the stop signal,
wherein furthermore the measuring arrangement, in particular the measuring unit, is designed to evaluate the transit time, and
- to carry out several individual measurements within a measuring cycle and feed the measuring signal at each individual measurement, wherein the threshold value is varied for different individual measurements,
- to determine a plurality of stop signals with different transit times by means of a plurality of individual measurements, wherein at each individual measurement the set threshold value and the transit time associated with the threshold value are recorded as a value pair and a signal curve is determined from the plurality of the value pairs, wherein
- after detection of a first stop signal in a first individual measurement, a second individual measurement with preferably the same threshold value as in the first individual measurement is carried out, wherein in the second individual measurement a measurement dead time is specified, which is greater than the transit time for the first stop signal acquired in the first individual measurement, so that the reflected portion assigned to the first stop signal is not detected in the second individual measurement and by the measuring dead time in combination with the variation of the threshold value, rising as well as falling edges in the signal curve are detected, wherein for the detection of a falling edge a stop signal is emitted when the value falls below the set threshold value,
- the line comprises several disruption points and each disruption point generates a partial reflection of the measurement signal, so that a characteristic pattern is formed, and
- by the plurality of stop signals a stop pattern characterizing the line is generated, and the stop pattern is compared with a reference pattern for a normal state of the line and checked for deviation, wherein
- the stop pattern and the reference pattern comprise several portions, each of which is generated by one of the disruption points, and the stop pattern and the reference pattern are formed by stop signals with different transit times.

13. Measuring arrangement according to claim 12, in which the measuring unit is integrated in a plug of the line or in a control unit of an (on-board) network or in a measuring device.

## Revendications

1. Procédé de surveillance d'une ligne, qui comprend un conducteur de mesure s'étendant le long de ladite ligne, dans lequel
- un signal de mesure est introduit dans le conducteur de mesure à une heure de démarrage,
- en présence d'un point de perturbation, le signal de mesure est au moins partiellement réfléchi audit point de perturbation,
- le conducteur de mesure est surveillé quant à une composante réfléchie, dans lequel respectivement un signal d'arrêt numérique est généré en cas de dépassement d'une valeur seuil et le temps de propagation entre l'heure de démarrage et le signal d'arrêt est détecté et évalué,
- plusieurs mesures individuelles sont effectuées au cours d'un cycle de mesure et le signal de mesure est introduit à chaque mesure individuelle, la valeur seuil étant modifiée pour les différentes mesures individuelles,
- au moyen d'une multitude de mesures individuelles, une multitude de signaux d'arrêt avec différents temps de propagation est déterminé, dans lequel lors de chaque mesure individuelle la valeur seuil réglée et le temps de propagation associé à cette valeur seuil sont enregistrés comme une paire de valeurs et à partir de la multitude des paires de valeurs une courbe de signal est déterminée, dans lequel
- après la détection d'un premier signal d'arrêt dans une première mesure individuelle, une deuxième mesure individuelle est effectuée avec de préférence la même valeur seuil que dans la première mesure individuelle, un temps mort de mesure étant spécifié dans la deuxième mesure individuelle, qui est supérieur au temps de propagation du premier signal d'arrêt détecté dans la première mesure individuelle, de sorte que la composante réfléchie affectée au premier signal d'arrêt n'est pas détectée dans la deuxième mesure individuelle et que le temps mort de mesure, en combinaison avec la variation de la valeur seuil, permet de détecter des fronts montants et descendants dans la courbe de signal, un signal d'arrêt étant émis pour la détection d'un front descendant lorsque la valeur passe en dessous de la valeur seuil réglée,
- la ligne comprend plusieurs points de perturbation répartis sur sa longueur et chaque point de perturbation génère une réflexion partielle du signal de mesure, de sorte qu'un modèle caractéristique est formé, et
- par la multitude des signaux d'arrêt, un modèle d'arrêt caractérisant la ligne est généré, et le modèle d'arrêt est comparé à un modèle de référence pour un état normal de la ligne et vérifié pour une déviation, dans lequel
- le modèle d'arrêt et le modèle de référence comprennent plusieurs composantes réfléchies, chacune d'entre elles étant générée par un des points de perturbation, et le modèle d'arrêt et le modèle de référence sont formés par des signaux d'arrêt avec différents temps de propagation.

2. Procédé selon la revendication 1, dans lequel un cycle de mesure est effectué avec plusieurs mesures individuelles successives, de sorte que plusieurs signaux d'arrêt avec différents temps de propagation sont obtenus, dans lequel lesdits plusieurs signaux d'arrêt s'étendent sur une plage s'élevant à au moins 10 % d'un temps de propagation total maximum que le signal de mesure nécessite pour se déplacer depuis un point d'alimentation jusqu'à une extrémité de ligne et retour au point d'alimentation.

3. Procédé selon l'une des revendications 1 à 2, dans lequel la valeur seuil est variée sur une plage correspondant à au moins 0,5 fois et de préférence au moins 0,75 fois l'amplitude du signal de mesure.

4. Procédé selon l'une des revendications 1 à 3, dans lequel par la variation de la valeur seuil un seuil de déclenchement est déterminé, sur la base duquel une mesure pour la grandeur d'une impédance caractéristique pour le signal de mesure est déterminée.

5. Procédé selon l'une des revendications 1 à 4, dans lequel le signal de mesure a une durée de signal, qui correspond à au moins deux fois le temps de propagation du signal à travers la ligne, de sorte que le signal de mesure est superposé à la composante réfléchie.

6. Procédé selon l'une des revendications 1 à 5, dans lequel la durée du signal de mesure est variée pour les différentes mesures.

7. Procédé selon l'une des revendications 1 à 6, dans lequel un modèle temporel à plusieurs lignes est généré, dans lequel dans chaque ligne les temps de propagation des signaux d'arrêt d'une valeur seuil définie, variant d'une ligne à l'autre, sont mémorisés.

8. Procédé selon l'une des revendications 1 à 7, dans lequel le modèle de référence est déterminé au moyen d'une mesure de référence sur la base de la ligne dans un état initial, en particulier après sa fabrication ou son installation dans un dispositif, et le modèle d'arrêt est ensuite mesuré, en particulier de manière répétée, pendant le temps de fonctionnement.

9. Procédé selon l'une des revendications 1 à 8, dans lequel le conducteur de mesure comprend un conducteur et une isolation entourant ce dernier avec une constante diélectrique dépendant de la température, de sorte qu'une modification de la température conduit à une modification du temps de propagation de la composante réfléchie, qui est évaluée par rapport à une charge de température, dans lequel une charge de température modifiée est de préférence déduite d'un décalage temporel du signal d'arrêt par rapport à une durée de référence.

10. Procédé selon la revendication 9, dans lequel la mesure du décalage temporel est mesurée et, à partir de celle-ci, une mesure de la charge thermique modifiée est déterminée.

11. Procédé selon l'une des revendications 1 à 10, dans lequel une variable de condition externe est détectée, en particulier un niveau de remplissage, qui change le long de la ligne.

12. Dispositif de mesure pour la surveillance d'une ligne, dans lequel la ligne comprend un conducteur de mesure s'étendant le long de la ligne, dans lequel le dispositif de mesure comprend une unité de mesure, et dans lequel l'unité de mesure est conçue pour être reliée au conducteur de mesure et ainsi
- pour alimenter un signal de mesure dans le conducteur de mesure à une heure de démarrage,
- pour surveiller une composante réfléchie à un point de perturbation,
- pour générer un signal d'arrêt numérique chaque fois qu'une valeur seuil est dépassée,
- pour enregistrer le temps de propagation entre l'heure de démarrage et le signal d'arrêt,
dans lequel, en outre, le dispositif de mesure, en particulier l'unité de mesure, est conçu pour évaluer le temps de propagation, et
- pour effectuer plusieurs mesures individuelles au cours d'un cycle de mesure et d'introduire le signal de mesure à chaque mesure individuelle, le valeur seuil étant modifiée pour les différentes mesures individuelles,
- pour déterminer une multitude de signaux d'arrêt avec différents temps de propagation au moyen d'une multitude de mesures individuelles, dans lequel lors de chaque mesure individuelle la valeur seuil réglée et le temps de propagation associé à la valeur seuil sont enregistrés comme une paire de valeurs et à partir de la multitude des paires de valeurs une courbe de signal est déterminée, dans lequel
- après détection d'un premier signal d'arrêt dans une première mesure individuelle, une deuxième mesure individuelle est effectuée avec de préférence la même valeur seuil que dans la première mesure individuelle, un temps mort de mesure étant spécifié dans la deuxième mesure individuelle, qui est supérieur au temps de propagation du premier signal d'arrêt détecté dans la première mesure individuelle, de sorte que la composante réfléchie affectée au premier signal d'arrêt n'est pas détectée lors de la deuxième mesure individuelle et que le temps mort de mesure, en combinaison avec la variation de la valeur seuil, permet de détecter des fronts montants et descendants dans la courbe de signal, un signal d'arrêt étant émis pour la détection d'un front descendant lorsque la valeur passe en dessous de la valeur seuil réglée,
- la ligne comprend plusieurs points de perturbation et chaque point de perturbation génère une réflexion partielle du signal de mesure, de sorte qu'un modèle caractéristique est formé, et
- par la multitude des signaux d'arrêt, un modèle d'arrêt caractérisant la ligne est généré, et le modèle d'arrêt est comparé à un modèle de référence pour un état normal de la ligne et vérifié pour la déviation, dans lequel
- le modèle d'arrêt et le modèle de référence comprennent plusieurs composantes réfléchies, chacune d'entre elles étant générée par un des points de perturbation, et le modèle d'arrêt et le modèle de référence sont formés par des signaux d'arrêt avec différents temps de propagation.

13. Dispositif de mesure selon la revendication 12, dans lequel l'unité de mesure est intégrée dans un connecteur de la ligne ou dans une unité de commande d'un réseau (de bord) ou dans un appareil de mesure.
